# EUROPÄISCHE PATENTSCHRIFT

(11) **EP 0 891 560 B1**
(45) Veröffentlichungstag und Bekanntmachung des Hinweises auf die Patenterteilung: **27.08.2003**
(21) Anmeldenummer: 97918063.5
(22) Anmeldetag: 02.04.1997
(51) Int. Cl.: G01R 33/04, G01B 7/30

(54) **STROMKOMPENSIERTER MAGNETFELDSENSOR UND VERWENDUNG DESSELBEN IN EINEM DREHWINKELSENSOR**
CURRENT-COMPENSATED MAGNETIC FIELD SENSOR AND ITS USE IN A SENSOR FOR ANGLES OF ROTATION
CAPTEUR DE CHAMPS MAGNETIQUES A COMPENSATION DE COURANT ET SON UTILISATION DANS UN CAPTEUR D'ANGLES DE ROTATION

(30) Priorität: 03.04.1996 DE 19613402
(43) Veröffentlichungstag der Anmeldung: 20.01.1999
(73) Patentinhaber: TYCO Electronics Logistics AG, 9323 Steinach (CH)
(72) Erfinder: BEICHLER, Johannes, D-63110 Rodgau (DE); PREUSSE, Norbert, D-63755 Alzenau (DE)
(74) Vertreter: Klunker . Schmitt-Nilson . Hirsch
(86) Internationale Anmeldenummer: DE9700672
(87) Internationale Veröffentlichungsnummer: WO97038323

(56) Entgegenhaltungen:
- EP-A- 0 483 369
- FR-A- 1 187 834
- GB-A- 2 239 713
- US-A- 5 039 945
- US-A- 5 148 106

## Beschreibung

Die Erfindung betrifft einen stromkompensierten Magnetfeldsensor mit einem vom zu erfassenden Magnetfeld beeinflußten Magnetkern, mit mindestens einer Spule, die den Magnetkern umgibt, und einer an die Spule angeschlossenen Stromquelle, die abwechselnd positive und negative Ströme solcher Amplitude in der Spule hervorruft, daß der Magnetkern gesättigt wird.

Aus DE 42 29 948 ist es bekannt, über die Erfassung des Magnetfeldes eines Kerns vorzugsweise aus amorphem Material mit hoher Permeabilität und geringen Wirbelstromverlusten einen in einer Primärwicklung des Magnetkerns fließenden Strom zu erfassen. Hierzu wird durch eine Sekundärwicklung auf dem Magnetkern ein Wechselstrom geschickt, der den Magnetkern abwechselnd in die positive oder negative Sättigung treibt. Abhängig von der durch den zu messenden Strom erzeugten Vormagnetisierung des Magnetkerns besitzt die Sekundärwicklung einen polaritätsabhängigen, unsymmetrischen Widerstand. Wenn man nun den Mittelwert des im Sekundärkreis mit der Sekundärwicklung fließenden Stromes aus einem aktuellen und einem vorhergehenden Meßwert bildet, erhält man einen wert für das im Magnetkern vorhandene Magnetfeld, der durch die Hysterese des weichmagnetischen Materials des Magnetkerns nicht mehr verfälscht wird. Aus diesem, dem Magnetfeld im Magnetkern proportionalem Wert kann dann auf die Größe des zu messenden Primärstromes geschlossen werden.

In US-A-5 039 945 ist ein Magnetfeldsensor mit einer kombinierten Erreger- und Kompensationsspule, welche als Sensorelement für das zu messende Magnetfeld dient. Die kombinierte Erreger- und Kompensationsspule weist einen von einer Wicklung umgebenen Magnetkern auf. Über einen steuerbaren Umschalter ist die Wicklung wahlweise an eine erste Spannungsquelle mit positiver Spannung oder an eine zweite Spannungsquelle mit negativer Spannung angeschlossen. Der durch die Wicklung fließende Erregerstrom, welcher den Magnetkern abwechselnd in positive und negative Sättigung treibt, wird einer Steuerungseinheit als Eingangsgröße zugeführt, welche ihrerseits ausgangsseitig ein Steuerungssignal für den Umschalter liefert. Die Ansteuerung des Umschalters erfolgt dabei derart, daß die Erregerstromspitzen während der positiven und negativen Halbwelle des Erregerstroms gleich groß sind.

Aus FR-A-1 187 834 ist eine Vorrichtung zur Bestimmung der Richtung eines Magnetfeldes bekannt, welche zwei senkrecht zueinander angeordnete Spulen aufweist. Jede dieser Spulen weist einen von einer Primär- und einer Sekundärwicklung umgebenen weichmagnetischen Kern auf. Jede Primärwicklungen ist dabei an eine Impulsstromquelle angeschlossen, welche eine zur Sättigung des zugehörigen Kernes ausreichende Amplitude erzeugt. Aus den an den Sekundärwicklungen induzierten Spannungsimpulsen ist die zu bestimmende Richtung des Magnetfeldes ableitbar.

Aufgabe der vorliegenden Erfindung ist es, unter Ausnutzung des Prinzips der abwechselnden positiven und negativen Sättigung eines Magnetkerns durch einen Strom eine einfache und dabei besonders genaue Methode zur Bestimmung eines externen Magnetfeldes anzugeben. Durch die Erfindung wird nicht nur ein durch die Hysterese des Magnetkerns bedingter Fehler vermieden, sondern man erreicht auch, daß das Meßergebnis unabhängig ist von Temperatureinflüssen und von vielen montagebedingten Ungleichheiten unterschiedlicher Exemplare des Magnetfeldsensors.

Die Lösung dieser Aufgabe besteht erfindungsgemäß darin, daß als Stromquelle eine Impulsstromquelle vorgesehen ist, die Stromimpulse mit stromlosen Zwischenräumen in der Spule erzeugt und daß die beim Einschalten und/oder nach Beendigung jedes Stromimpulses auftretende Änderung des Magnetfeldes im Magnetkern je einen Einschalt- oder Rücksetzimpuls erzeugt, die einen Kompensationsstrom in einer den Magnetkern umgebenden Spule so steuern, daß die positiven und negativen Einschalt- oder Rücksetzimpulse gleich groß sind.

Der erfindungsgenäße, strankompensierte Magnetteldsensor eignet sich mit besonderem Vorteil für die Anwendung in einem Drehwinkelsensor, bei dem ein gegenüber dem stromkompensierten Magnetfeldsensor rotierendes Feld gemessen und in einer Auswerteschaltung auf den Winkel des gegenüber dem Magnetfeldsensor rotierenden Feldes geschlossen werden kann. In einer bevorzugten Anordnung werden zwei senkrecht aufeinanderstehende Magnetfeldsensoren ausgenutzt, um eindeutig eine Winkelmessung zwischen 0 und 360° für ein sich drehendes Teil zu erreichen.

Ausführungsbeispiele der Erfindung sind in den Figuren dargestellt:
Fig. 1 zeigt das Blockschaltbild eines erfindungsgemäßen stromkompensierten Magnetfeldsensors;
Fig. 2 zeigt die bei verschiedenen Feldstärken durch die Stromimpulse erzeugten Spannungen;
Fig. 3 zeigt den Spannungsverlauf an der Spule für den Fall, daß durch die Spule ein eingeprägter dreieckförmiger Strom fließt;
Fig. 4 den Verlauf der Kompensationsströme in den Sensoren nach Anspruch 3 bei Drehung der Drehachse um 360°;
Fig. 5 den Quotienten aus den Kompensationsspannungen der beiden Sensoren im Verlauf eines halben Quadranten;
Fig. 6 die Verwendung von zwei erfindungsgemäßen, stromkompensierten Magnetfeldsensoren zur Messung des Drehwinkels eines sich drehenden Teils;
Fig. 7 ein Blockschaltbild des mit zwei stromkompensierten Magnetfeldsensoren arbeitenden Drehwinkelsensors.

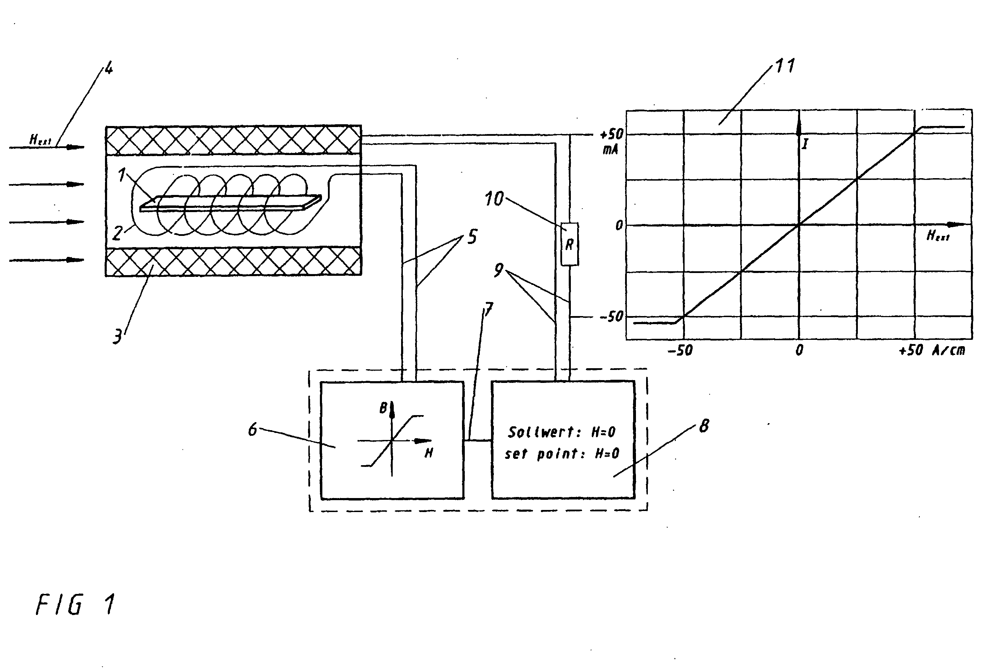

In Fig. 1 ist ein erfindungsgemäßer Magnetfeldsensor dargestellt, der im wesentlichen aus einem längsgestreckten Magnetkern 1 und einer den Magnetkern umgebenen Spule 2 besteht. Die Spule 2 wird ferner von einer weiteren Spule 3 umgeben, durch die der Kompensationsstrom fließen soll. Die Pfeile 4 kennzeichnen die Feldlinien eines externen Magnetfeldes, dessen Größe von dem stromkompensierten Magnetfeldsensor zu bestimmen ist.

Dieses Magnetfeld kann entweder - wie nachstehend beschrieben - das Magnetfeld eines Drehwinkelgebers sein, kann aber auch ein beliebiges anders Magnetfeld sein, beispielsweise das Magnetfeld, das von einem zu messenden Primärstrom herrührt, wie es bei Stromsensoren der Fall ist.

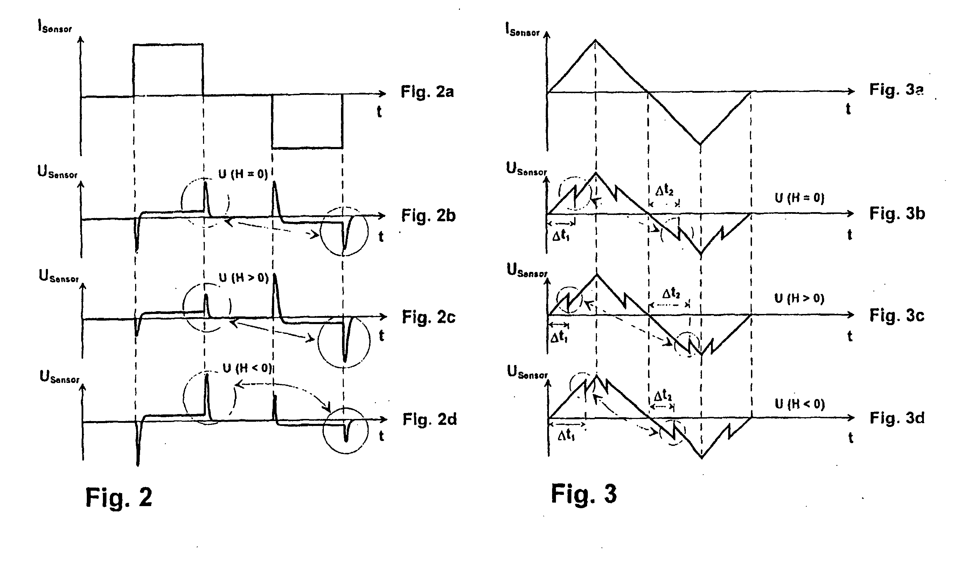

Die Anschlüsse der Spule 2 sind über Leitungen 5 an einen Auswertebaustein 6 angeschlossen. Dieser Auswertebaustein 6 enthält, wie im einzelnen nicht näher dargestellt ist, eine Stromquelle, welche rechteckförmige Stromimpulse solcher Größe durch die Spule 2 schickt, daß der Magnetkern 1 durch die Stromimpulse in positiver und in negativer Richtung in die Sättigung gelangt. Der Stromverlauf in der Spule 2 ist in Fig. 2a dargestellt. Man sieht, daß zwischen zwei aufeinanderfolgenden Stromimpulsen in positiver und negativer Richtung jeweils eine stromlose Pause vorhanden ist. Für den Fall, daß kein externes Feld vorhanden ist, ergibt sich an den Leitungen 5 eine Spannung, wie sie Fig. 2b zeigt. An den Flanken des eingeprägten Stroms wird durch Selbstinduktion jeweils ein Spannungsimpuls induziert, dessen Höhe vom Magnetisierungszustand des Kerns und damit von der äußeren Feldstärke abhängt. Zwischen diesen Impulsen ist die Spannung entsprechend der Amplitude des eingeprägten Stroms konstant. Speziell beim Abschalten des eingeprägten Stroms wird das im Magnetkern 1 durch den Strom in der Spule 2 erzsugte Magnetfeld wieder zu Null. Durch diese Magnetfeld-änderung von der Sättigungsinduktion bis etwa auf Null entsteht ein Rücksetzimpuls, der in der Spule 2 induziert wird. In Fig. 2 sind die Rücksetzimpulse durch die Impulsspannungen umgebende Kreise gekennzeichnet.

Im Fall der Fig. 2b - also bei fehlendem externen Feld - sieht man, daß die Rücksetzimpulse nach einem positiven und nach einem negativem Stromfluß die gleiche Amplitude aufweisen. Dies liegt daran, daß die Magnetisierungskennlinie des weichmagnetischen Materials des Magnetkerns 1 immer symmetrisch ist und das äußere Magnetfeld definitionsgemäß den Wert Null hat.

Falls ein positives externes Magnetfeld vorhanden ist, wie beispielsweise durch die Pfeile 4 gekennzeichnet, so wird im Magnetkern 2 von der Ausgangsstellung ohne strom in der Spule 2 der Induktionshub in der einen Richtung verkleinert und in der anderen entsprechend vergrößert. Dies hat zur Folge, wie Fig. 2c zeigt, daß beispielsweise nach einem positiven Stromfluß in der Spule 2 eine geringere Ummagnetisierung des Magnetkerns 1 erfolgt, also sich auch ein kleinerer Rücksetzimpuls einstellt. Der Rücksetzimpuls nach einem negativen Stromfluß ist damit jedoch vergrößert, da die Induktionsänderung im Magnetkern 1 von der negativen Sättigung bis zum positiven Induktionswert entsprechend des externen Feldes gegenüber der Ausgangssituation nach Fig. 2b größer ist.

Das Umgekehrte ergibt sich, wenn das externe Feld eine andere Richtung hat, also kleiner Null ist. In diesem Fall wird nach einem positiven Stromfluß ein größerer und nach einem negativen Stromfluß ein kleinerer Rücksetzimpuls ausgelöst. Dies zeigt Fig. 2d.

Die Schaltung im Auswertebaustein 6 integriert nun die Rücksetzimpulse, die nach jedem Stromfluß auftreten. Abhängig davon, ob dieses Integral einen positiven oder einen negativen Wert ergibt, wird jetzt die Ausgangsspannung am Ausgang 7 des Auswertebausteins 6 so verändert, daß eine an den Ausgang 7 angeschlossene Regelschaltung 8 an deren Ausgangsleitungen 9 eine mehr oder weniger große Spannung solcher Polarität erzeugt, daß in der über den Widerstand 10 angeschlossenen weiteren Spule 3 des Magnetfeldsensors ein in Größe und Richtung so dimensionierter Kompensationsstrom fließt, daß im Innern der Spule 3 ein Feld erzeugt wird, das dem durch die Pfeile 4 gekennzeichneten externen Feld entgegengerichtet und gleich groß ist.

Der Kompensationsstrom wird also so geregelt, daß das Integral über die positiven und negativen Rücksetzimpulse Null ist, also gleiche Impulse nach positivem bzw. negativem Stromimpuls festgestellt werden. Hierdurch ergibt sich, daß der Strom in den Leitungen 9 und damit der Spannungsabfall am Widerstand 10 im Rahmen der durch die Versorgungsspannung der Schaltung gesetzten Grenzen einen streng proportionalen Wert zum externen Feld besitzt, das auf den Magnetfeldsensor bzw. auf den Magnetkern 1 einwirkt.

Das Diagramm 11 zeigt die Abhängigkeit des Kompensationsstromes I von dem durch die Pfeile 4 dargestellten externen Feld Hₑₓₜ. Diese Anordnung mit einem Auswertebaustein 6, der den Kompensationsstrom so regelt, daß im Innern des Magnetfeldsensors jeweils der Fluß Null herrscht, hat den Vorteil, daß nicht nur Wirbelstromverluste im Magnetkern, sondern auch Temperatureinflüsse und Variationen durch Montage- und/oder Fertigungsungenauigkeiten der Spule 2 oder des Magnetkerns 1 keinen Einfluß auf das Meßergebnis ausüben.

Anstelle von Stromimpulsen mit stromlosen Pausen kann man durch die Spule des erfindungsgemäßen Sensors auch einen eingeprägten Dreieckstrom fließen lassen. Durch diesen Dreieckstrom wird ebenfalls der Magnetkern 1 abwechselnd in die positive bzw. negative Sättigung getrieben. Der Stromverlauf bei eingeprägtem dreieckförmigem Strom ist in Fig. 3a dargestellt. Die Variante mit Dreieckstrom gemäß Fig.3 füllt nicht unter dem Wortlaut des Anspruchs 1. Die Fig. 3b, 3c und 3d zeigen entsprechend Fig. 2 die Verhältnisse ohne Feld, bei positivem Feld und bei negativem Feld. Bei ansteigendem Strom - ausgehend vom Nullpunkt - ist der Magnetkern 1 zunächst noch nicht gesättigt, besitzt also einen durch die relative Permeabilität des Magnetkerns definierten induktiven Widerstand. Hierbei ist vorausgesetzt, daß das Material des Magnetkerns keine rechteckige Magnetisierungsschleife besitzt, sondern beispielsweise durch Querfeldtemperung des Materials eine mit zunehmender Feldstärke stetig zunehmende Induktion aufweist, also eine sogen. flache Schleife besitzt. Sobald das Feld so groß geworden ist, daß der Kern gesättigt wird, verhält sich dieser wie Luft, d. h. die relative Permeabilität ist Eins. Dadurch verringert sich der induktive Widerstand der Spule 2 auf einen kleineren Wert. Dies hat zur Folge, daß der Spannungsabfall in der Spule (in den Fig. 2b bis d und 3d bis d mit U _{Sensor} bezeichnet) geringer wird und sich mehr oder weniger sprungartig auf einen kleineren Wert vermindert. Dies geschieht für die positive und negative Halbwelle des Dreieckstroms bei fehlendem externen Feld entsprechend Fig. 3b symmetrisch zur Zeitachse t, während bei positivem Feld entsprechend Fig. 3c der Sättigungspunkt bei positiver Halbwelle eher und bei negativer Halbwelle später erreicht wird. Umgekehrt wird der Spannungssprung bei negativem Feld und positiver Halbwelle später und negativer Halbwelle früher einsetzen. Dies zeigt Fig. 3d. In der Auswerteschaltung ist es nun möglich, wahlweise die Zeiten des Spannungspunktes bezogen auf den Null-Durchgang der Spannung zu vergleichen, oder aber die Amplituden vor bzw. nach jedem Spannungssprung. Die Zeiten sind mit Δ t1 und Δt2 in Fig. 3 bezeichnet. Die Kreise zeigen wieder die zur Auswertung herangezogenen Spannungsimpulse. Selbstverständlich kann man auch die anderen sprungartigen Spannungsänderungen, wenn nämlich bei fallendem Strom der Magnetkern 1 aus der Sättigung in die ungesättigte Phase übergeht, verwenden. Analog zur Impulshöhe nach Fig. 2 läßt sich nun durch den Auswertebaustein 6 das Verhältnis der Zeiten Δt1 und Δt2 oder das Verhältnis der Amplituden, bei denen eine sprunghafte Spannungsänderung erfolgt, feststellen und abhängig davon läßt sich der Kompensationsstrom wiederum so einstellen, daß sich symmetrische Verhältnisse nach Fig. 3b einstellen.

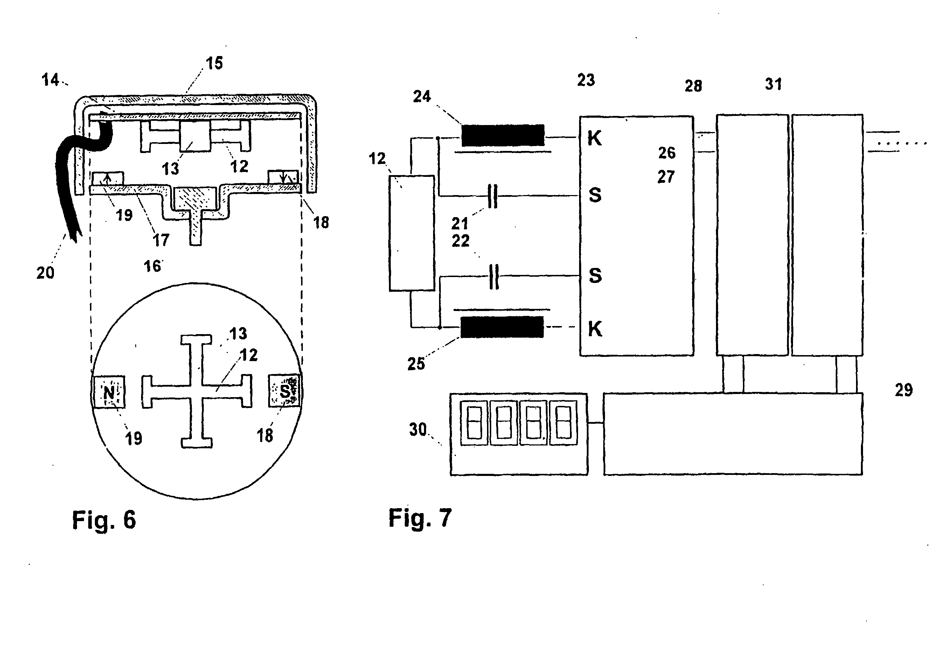

Als Anwendungsbeispiel für den erfindungsgemäßen, stromkompensierten Magnetfeldsensor ist beispielsweise in Fig. 6 schematisch der Aufbau eines Drehwinkelgebers dargestellt. Hier sind zwei der in Fig. 1 beschriebenen Magnetfeldsensoren 12 und 13 so angeordnet, daß sich deren Magnetkerne in einer Ebene befinden und die Längsrichtungen der Magnetkerne jeweils 90° Winkel einschließen. Die Anordnung der Magnetkerne in einer Ebene ist möglich, wenn die Spulen in der Mitte jedes Magnetkerns entsprechend unterbrochen werden. Die Magnetfeldsensoren 12 und 13 sind ortsfest an einer Platte 14 in einem Abschirmgehäuse 15 befestigt. Mit einer Drehachse 16, deren Winkelstellung erfaßt werden soll, ist eine Eisenplatte 17 verbunden, auf der Magnete 18 und 19 so aufgebracht sind, daß sie im Bereich der Magnetfeldsensoren 12 und 13 bei Drehung der Drehachse 16 ein rotierendes Magnetfeld erzeugen. Die Eisenplatte 17 dient dabei gleichzeitig als magnetischer Rückschluß, als magnetische Abschirmung nach dieser Seite und als Träger für die Magnete 18 und 19.

Im vorliegenden Fall sind die Magnete drehbar und die Magnetfeldsensoren ortsfest angeordnet. Dies hat den Vorteil, daß die elektrischen Leitungen - wie die Zuleitung 20 zeigt -, direkt an die Anschlüsse der Spulen in den Magnetfeldsensoren angeschlossen werden können und keine Schleifringe oder dgl. erforderlich sind. Im Prinzip ist es allerdings ohne weiteres möglich, das Magnetfeld ortsfest anzuordnen und die Sensoren drehbar in dem Magnetfeld zu lagern.

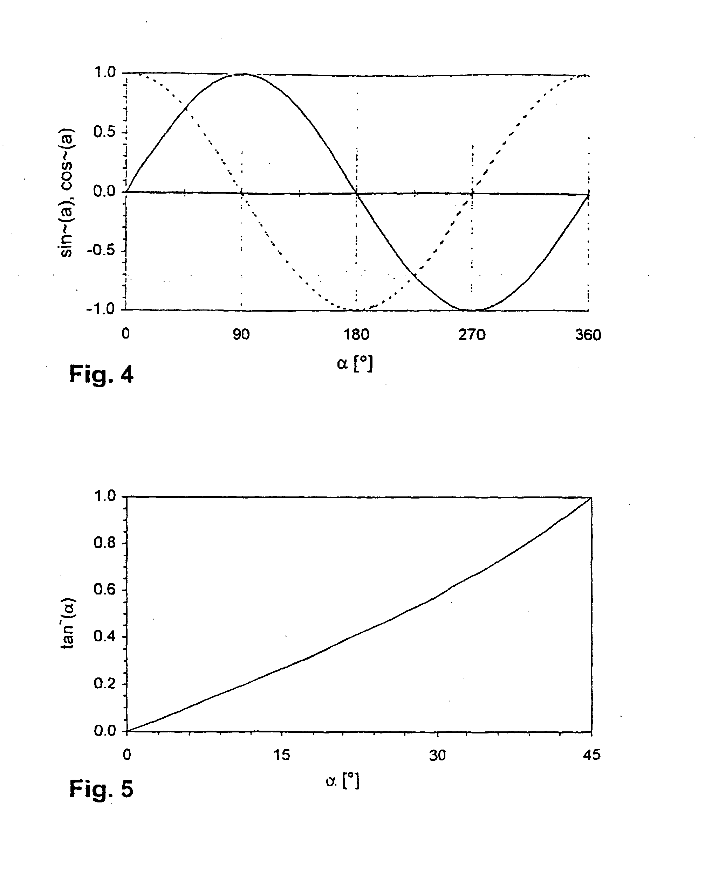

Die Magnetfeldsensoren 12 und 13 besitzen jeweils längsgestreckte Magnetkerne. Deren Kompensationsstrom wird so eingestellt, daß das in Richtung der Magnetkerne wirkende Feld - also nur eine Feldkomponente - jeweils auf den Wert Null geregelt wird. Sie sind daher jeweils auch nur für eine Feldrichtung empfindlich und bei Drehung der Drehachse 16 um 360° ergeben sich die in Fig. 4 dargestellten annähernd sinus- bzw. kosinusförmigen Kurven. Fig. 4 zeigt dabei den Drehwinkel zwischen 0 und 360° auf der Abszisse und den Wert der Ausgangsspannung, wie sie beispielsweise am Widerstand 10 in Fig. 1 auftritt, der Sensoren als durchgezogene Kurve beispielsweise für den Magnetfeldsensor 12 und als gestrichelt gezeichnete Kurve beispielsweise für den Magnetfeldsensor 13. Die Phasenverschiebung zwischen diesen beiden Kurven entspricht 90° entsprechend dem räumlichen Winkel zwischen den Magnetfeldsensoren 12 und 13.

Damit kann man abhängig von dem Vorzeichen der Ausgangsspannungen der beiden Magnetfeldsensoren vier Quadranten unterscheiden. Im Bereich von 0 bis 90° sind die Ausgangsspannungen beide positiv; im Bereich von 90 bis 180° ist die Ausgangsspannung des Magnetfeldsensors 12 positiv und diejenige des Magnetfeldsensors 13 negativ. Im Bereich von 180 bis 270° sind die Ausgangsspannungen beider Magnetfeldsensoren negativ und im Bereich zwischen 270 und 360° ist die Ausgangsspannung des Magnetfeldsensors 12 negativ und diejenige des Magnetfeldsensors 13 positiv.

Erfindungsgemäß wurde nun weiter erkannt, daß der Drehwinkel α oder die Stellung der Welle 13 relativ zu einer Ausgangsstellung sich dann am genauesten ermitteln läßt, wenn sich die vom Kompensationsstrom hervorgerufene Spannung am Widerstand 10 möglichst schnell abhängig vom Winkel ändert, die Kurven in Fig. 4 also möglichst steil verlaufen. Besonders vorteilhaft ist es daher, wenn man jeweils die Kurvenelemente der Ausgangsspannungen der Magnetfeldsensoren 12 und 13 verwendet, die den kleineren Absolutwert aufweisen, da hier die Änderung des Kompensationsstromes mit dem Winkel am größten ist.

Erfindungsgemäß wird daher in einer später in Fig. 6 noch beschriebenen Anpaßschaltung der Quotient aus dem betragsmäßig jeweils kleineren zum größeren Wert der beiden in Fig. 4 dargestellten Werte der Kurven ermittelt. Dieser Quotient gibt einen ungefähr tangensförmigen Verlauf, wie er in Abhängigkeit vom Winkel α für einen Bereich von Null bis 45° in Fig. 5 dargestellt ist.

Abhängig davon, ob die Ausgangsspannung des Magnetfeldsensors 12 oder diejenige des Magnetfeldsensors 13 größer ist, läßt sich für jeden Quadranten entscheiden, ob der Bereich von 0° bis 45° oder der Bereich von 45° bis 90° relevant ist.

Die in Fig. 5 dargestellte Abhängigkeit des gemessenen Quotienten bei Quotientenbildung des kleineren zum größeren Wert der Ausgangsspannungen in jedem halben Quadranten ist kein reiner Tangens, zumal die in Fig. 6 dargestellte Anordnung nur ungefähr eine reine Sinus- bzw. Kosinusfunktion liefert, und zumal Einbaudifferenzen, Abstand Eisenplatte 17 zu Magnetfeldsensoren 12 und 13 und auch andere Toleranzen für jedes System gewisse Abweichungen bedingen. Diese Abweichungen beinhaltet der Quotient jedoch in wesentlich schwächerer Weise als die reinen sinus- und cosinusförmigen Abhängigkeiten, da sich Einflüsse, die nur die Amplitude der Einzelkurven beeinflussen, im Quotienten herauskürzen können, wenn sie dies in gleicher Weise tun. Daher müssen die Magnetkerne der Sensoren 12 und 13 möglichst eng benachbart sein.

Es ist daher vorteilhaft, in einem Testlauf bei bekannten Winkelstellungen α jeweils den gemessenen Quotienten aus den Spannungen der Sensoren im Bereich 0 ... 45° zu ermitteln und in einer Tabelle bzw. in einer Kurve festzuschreiben. Damit läßt sich aus dieser Tabelle für jeden Wert des Spannungsquotienten der Winkel ermitteln.

Eine Auswerteschaltung, die dieses leistet, ist schematisch in Fig. 7 dargestellt. Hier ist für die Magnetfeldsensoren 12 und dem dort nicht dargestellten Magnetfeldsensor 13 eine Anordnung gewählt, bei der um den Magnetkern 1 nur eine Spule 2 herumgewickelt ist. Diese Spule ist über Kondensatoren 21 und 22 einerseits an Eingänge S eines Elektronikmoduls 23 angeschlossen und andererseits über Drosseln 24 und 25 mit Eingängen K des Elektronikmoduls 23 verbunden. Da die Impulsströme, die den Magnetkern 1 in die Sättigung treiben, eine wesentlich höhere Frequenz aufweisen als der dem externen zu messenden Feld folgende Kompensationsstrom, ist es auf diese Weise möglich, sowohl den Kompensationsstrom über die Drosseln 24 und 25 als auch die Impulsströme über die Kondensatoren 21 und 22 über die gleiche Spule 2 zu schicken.

Auf diese Weise kann der Magnetfeldsensor einfacher, als in Fig. 1 beschrieben, aufgebaut sein. Im übrigen erfüllt der Elektronikmodul 23 die Funktionen, wie anhand des Auswertebausteins 6 und der Regelschaltung 8 beschrieben.

Zwischen den Ausgangsleitungen 26 und 27 ergibt sich damit eine Spannung, die beispielsweise zwischen den Werten -5 V und +5 V schwankt, abhängig von der Größe des vom Magnetfeldsensor 12 erfaßten externen Magnetfeldes. Die Ausgangsleitungen 26 und 27 sind an den Eingang einer Anpaßschaltung 28 angeschlossen, die ausgangsseitig an den Eingang eines Microcontrollers 29 geführt ist. Die Anpaßschaltung ändert die Eingangsspannung, die zwischen den Werten von beispielsweise -5V und +5 V schwankt, auf eine Ausgangsspannung, die z. B. zwischen den Werten 0 und +5 V liegt.

In gleicher Weise wie die Anpaßschaltung 28 ist die Anpaßschaltung 31 aufgebaut. Sie ist - wie nicht näher dargestellt ist - wie die Anpaßschaltung 28 mit dem Magnetfeldsensor 12 - mit dem Magnetfeldsensor 13 verbunden, dessen Winkellage sich um 90° gegenüber dem Magnetfeldsensor 12 unterscheidet. Auch am Ausgang der Anpaßschaltung 31 entsteht so eine Spannung zwischen jeweils 0 und 5 V abhängig von dem Magnetfeld, das auf den Magnetfeldsensor 13 einwirkt.

In dem Microcontroller 29 ist nun die Tabelle bzw. Kurve nach Fig. 5 gespeichert, die den Zusammenhang zwischen dem Quotienten aus dem betragsmäßig größeren und dem betragsmäßig kleineren Sensorsignal und dem tatsächlichen Winkel a der Drehachse 16 herstellt. Im Microcontroller 29 sind außerdem die logischen Schaltungen vorgesehen, die abhängig von der Größe der Ausgangsspannung der beiden Magnetfeldsensoren 12 und 13 den Quotienten aus der betragsmäßig kleineren und größeren Ausgangsspannung bilden und anhand der Größe der Spannungen mit Hilfe der Tabelle nach Fig. 5 einen Winkel zwischen 0 ... 45° bzw. zwischen 45 ... 90° zuordnen, und die abhängig von der Polarität der Ausgangsspannungen der beiden Magnetfeldsensoren 12 und 13 (wie dies anhand Fig. 4 beschrieben wurde) feststellen, in welchem Quadranten zwischen 0 und 360° sich die Drehachse 16 befindet.

Während - bedingt durch die Kompensationsregelung - sich am Ausgang des Elektronikmoduls 23 immer Spannungen einstellen, die symmetrisch zum Wert Null sind, kann bedingt durch Temperatureinflüsse und durch Auslegung am Ausgang der Anpaßschaltung, der beispielsweise den Bereich von 0 bis +5 V abdecken soll, ein Mittelwert auftreten, der sich von dem rechnerischen Mittelwert 2,5 V unterscheidet. Um diesen Fehler, der auch durch Exemplarstreuungen der verwendeten Anpaßschaltungen und sonstigen Komponenten auftreten kann, zu vermeiden, kann der Microcontroller vorteilhafterweise so programmiert werden, daß er die Spannungswerte, die von den Anpaßschaltungen 28 und 30 geliefert werden, über beispielsweise 10 Umdrehungen oder gezielt bei 0, 90, 180 und 270° verfolgt und damit für jede Anpaßschaltung getrennt das Minimum und das Maximum sowie den sich daraus ergebenden Mittelwert feststellt.

Wenn man diesen so ermittelten Mittelwert anstatt des rechnerischen Mittelwertes von beispielsweise 2,5 V als Bezugsspannung für die Auswertung heranzieht und einen sich aus Mittelwert und Minimum/Maximum ergebenden korrigierten Amplitudenwert berücksichtigt, so werden auch bei Montagefehlern oder bei Exemplarstreuungen durch nicht gleichmäßige Wicklung der Spule oder dgl. dadurch hervorgerufene Fehler ausgeglichen.

Man kann dazu z. B. in der Endprüfung jedes Drehwinkelsensors diesen Schritt durchführen und die ermittelten Parameter einschließlich des Mittelwertes in einem nicht flüchtigen Speicher ablegen. Man erhält damit eine optimale Genauigkeit auch bei nicht optimal montierten Systemen oder ohne daß man Abgleichmaßnahmen mechanischer Art durchführen muß. Der Microcontroller 29 kann somit mit Hilfe der aus den Vorzeichenwerten nach Fig. 4 und den Differenzwerten der beiden Ausgangsspannungen der Magnetfeldsensoren 12 und 13 sowie unter Heranziehung des Kurvenverlaufs entsprechend Fig. 5 die Winkelstellung der Drehachse 16 ermitteln und beispielsweise an eine Anzeigeeinrichtung 30 oder an eine weitere Steuer- bzw. Regelschaltung je nach Anwendung geben.

## Patentansprüche

1. Stromkompensierter Magnetfeldsensor mit einem vom zu erfassenden Magnetfeld beeinflußten Magnetkern (1), mit mindestens einer Spule (2, 3), die den Magnetkern umgibt, und einer an die Spule angeschlossenen Stromquelle, die abwechselnd positive und negative Ströme solcher Amplitude in der Spule hervorruft, daß der Magnetkern gesättigt wird,
**dadurch gekennzeichnet, daß** als Stromquelle eine Impulsstromquelle vorgesehen ist, die Stromimpulse mit stromlosen Zwischenräumen in der Spule (2) erzeugt,und daß die beim Einschalten und/oder nach Beendigung jedes Stromimpulses auftretende Änderung des Magnetfeldes im Magnetkern (1) je einen Einschalt- bzw. Rücksetzimpuls erzeugt, die einen Kompensationsstrom in einer den Magnetkern (1) umgebenden Spule (3) so steuern, daß die positiven und negativen Einschalt- bzw. Rücksetzimpulse gleich groß sind.

2. Stromkompensierter Magnetfeldsensor nach Anspruch 1,
**dadurch gekennzeichnet, daß** zusätzlich durch die die Stromimpulse führende Spule (2) eine weitere Spule (3) um den Magnetkern gewickelt ist, in welcher der Kompensationsstrom fließt.

3. Stromkompensierter Magnetfeldsensor nach Anspruch 1
**dadurch gekennzeichnet, daß** der Inpulsstrom und der Kompensationsstrom in einer einzigen den Magnetkern umgebenden Spule (2) fließen, wobei der höherfrequente Impulsstrom über eine Kapazität und der niedrigfrequente Kompensationsstrom über eine Induktivität an die Spule angeschlossen ist.

4. Stromkompensierter Magnetfeldsensor nach den vorhergehenden Ansprüchen zur Bildung eines Drehwinkelsensors,
**dadurch gekennzeichnet, daß** zwei stromkompensierte Magnetfeldsensoren (12, 13) senkrecht zueinander angeordnet sind und einem sich gegenüber den Magnetfeldsensoren drehenden Magnetfeld ausgesetzt sind, daß die Vorzeichen der Kompensationsströme in den beiden Magnetfeldsensoren zur Bestimmung des Quadranten des zu messenden Drehwinkels verwendet werden und daß das Größenverhältnis der Kompensationsströme zur Bestimmung des Winkels innerhalb des Quadranten dient.

5. Stromkompensierter Magnetfeldsensor nach Anspruch 4,
**dadurch gekennzeichnet, daß** die Differenz der Absolutwerte der Spannungen der Magnetfeldsensoren innerhalb eines Quadranten verwendet wird, um zu bestimmen, ob der Winkel in der ersten oder zweiten Hälfte dieses Quadranten liegt, und daß als Meßgröße für den Winkel jeweils der Quotient des kleineren zum größeren Wert der Kompensationsströme dient.

6. Stromkompensierter Magnetfeldsensor nach Anspruch 5,
**dadurch gekennzeichnet, daß** zur Bestimmung des Zusammenhangs zwischen Drehwinkel und den Quotienten des größeren zum kleineren Kompensationsstrom der Drehwinkelsensor dadurch abgeglichen wird, daß bei definierten Drehwinkelstellungen innerhalb eines halben Quadranten der Zusammenhang gemessen und in einer Referenzkurve bzw. Referenztabelle festgehalten wird, so daß bei gegebenem Verhältnis der beiden Konpensationsspannungen der Magnetfeldsensoren ein Mikroprozessor zur Auswertung der Ergebnisse aus dem berechneten Verhältnis den tatsächlichen Drehwinkel ermitteln kann.

7. Stromkompensierter Magnetfeldsensor nach Anspruch 6,
**dadurch gekennzeichnet, daß** die Referenztabelle zu Beginn jeder Inbetriebnahme automatisch in einen flüchtigen Speicher geschrieben wird.

8. Stromkompensierter Magnetfeldsensor nach Anspruch 6,
**dadurch gekennzeichnet, daß** die Referenztabelle für jeden Drehwinkelsensor einmal aufgenommen und in einen nicht flüchtigen Speicher geschrieben wird.

9. Stromkompensierter Magnetfeldsensor nach Anspruch 6 bis 8
**dadurch gekennzeichnet, daß** das Magnetfeld zur Beeinflussung der Magnetfeldsensoren durch Magnete (18, 19) erzeugt wird, die auf einem mit dem rotierenden Teil (16) verbundenen Magnetträger (17) aufgebracht sind.

10. Stromkompensierter Magnetfeldsensor nach Anspruch 8,
**dadurch gekennzeichnet, daß** der Magnetträger (17) aus weichmagnetischem Material besteht, so daß er gleichzeitig als magnetischer Rückschluß für den Fluß der Magnete (18, 19) und als Teil der magnetischen Abschirmung dient.

11. Stromkompensierter Magnetfeldsensor nach den Ansprüchen 6 bis 10, **dadurch gekennzeichnet, daß** die Magnetfeldsensoren (12, 13) gekreuzt so angeordnet sind, daß sich die Magnetkerne der Magnetfeldsensoren in einer Ebene befinden.

## Claims

1. Current-compensated magnetic field sensor comprising a magnet core (1) influenced by the magnetic field to be detected, comprising at least one coil (2, 3) surrounding the magnet core, and comprising a current source, which is connected to the coil and produces alternately positive and negative currents of such amplitude in the coil that the magnet core is saturated, **characterised in that** as a current source a power pulse current source is provided, which generates current pulses with idle intervals in the coil (2), and that the variation of the magnetic field in the magnet core (1) that occurs at the start and/or on completion of each current pulse generates in each case a starting and/or resetting pulse, by means of which a compensating current in a coil (3) surrounding the magnet core (1) is controlled in such a way that the positive and negative starting and/or resetting pulses are of equal magnitude.

2. Current-compensated magnetic field sensor according to claim 1, **characterised in that** in addition by means of the coil (2) carrying the current pulses a further coil (3), in which the compensating current flows, is wound around the magnet core.

3. Current-compensated magnetic field sensor according to claim 1, **characterised in that** the pulse current and the compensating current flow in a single coil (2) surrounding the magnet core, wherein the higher-frequency pulse current is connected by a capacitor and the lower-frequency compensating current is connected by an inductor to the coil.

4. Current-compensated magnetic field sensor according to the preceding claims for forming an angle-of-rotation sensor, **characterised in that** two current-compensated magnetic field sensors (12, 13) are disposed at right angles to one another and exposed to a magnetic field rotating relative to the magnetic field sensors, that the signs of the compensating currents in the two magnetic field sensors are used to determine the quadrant of the angle of rotation to be measured and that the magnitude ratio of the compensating currents is used to determine the angle within the quadrant.

5. Current-compensated magnetic field sensor according to claim 4, **characterised in that** the difference of the absolute values of the voltages of the magnetic field sensors within a quadrant is used to determine whether the angle lies in the first or second half of said quadrant, and that the quotient of the smaller to the larger value of the compensating currents is used as a measured quantity for the respective angle.

6. Current-compensated magnetic field sensor according to claim 5, **characterised in that**, in order to determine the relationship between angle of rotation and the quotient of the larger to the smaller compensating current, the angle-of-rotation sensor is adjusted **in that**, for defined angle-of-rotation positions within a half quadrant, the relationship is measured and recorded in a reference curve or reference table so that for a given ratio of the two compensating voltages of the magnetic field sensors a microprocessor for evaluating the results may determine the actual angle of rotation from the calculated ratio.

7. Current-compensated magnetic field sensor according to claim 6, **characterised in that** at the beginning of each startup the reference table is automatically written into a volatile memory.

8. Current-compensated magnetic field sensor according to claim 6, **characterised in that** the reference table for each angle-of-rotation sensor is received once and written into a non-volatile memory.

9. Current-compensated magnetic field sensor according to claim 6 to 8, **characterised in that** the magnetic field for influencing the magnetic field sensors is generated by magnets (18, 19), which are mounted on a magnet holder (17) connected to the rotating part (16).

10. Current-compensated magnetic field sensor according to claim 8, **characterised in that** the magnet holder (17) is made of magnetically soft material so that it serves simultaneously as a magnetic return for the flux of the magnets (18, 19) and as part of the magnetic screening.

11. Current-compensated magnetic field sensor according to claims 6 to 10, **characterised in that** the magnetic field sensors (12, 13) are disposed in a crossed manner such that the magnet cores of the magnetic field sensors are situated in one plane.

## Revendications

1. Capteur de champ magnétique à compensation de courant comprenant un noyau magnétique (1) influencé par un champ magnétique devant être détecté, au moins une bobine (2, 3) entourant le noyau magnétique et une source de courant raccordée à la bobine, induisant alternativement dans la bobine des courants positifs et négatifs avec une amplitude telle à saturer le noyau magnétique, **caractérisé en ce que** la source de courant est constituée par une source de courant d'impulsion, produisant des impulsions de courant avec des intervalles sans courant dans la bobine (2) et **en ce que** le changement du champ magnétique produit lors du branchement et/ou après la fin de chaque impulsion de courant une impulsion de branchement et/ou une impulsion de réinitialisation dans le noyau magnétique (1), assurant le réglage d'un courant de compensation dans une bobine (3) entourant le noyau magnétique (1) de sorte que les impulsions de branchement et/ou de réinitialisation positives et négatives ont la même valeur.

2. Capteur de champ magnétique à compensation de courant selon la revendication 1, **caractérisé en ce qu'**en plus de la bobine (2) comportant les impulsions de courant, une bobine additionnelle (3) est enroulée autour du noyau magnétique, traversée par le courant de compensation.

3. Capteur de champ magnétique à compensation de courant selon la revendication 1, **caractérisé en ce que** le courant d'impulsion et le courant de compensation s'écoulent dans une seule bobine (2) entourant le noyau magnétique, le courant d'impulsion à fréquence plus élevée étant relié à la bobine par un condensateur, le courant de compensation à fréquence réduite y étant raccordé par l'intermédiaire d'une inductance.

4. Capteur de champ magnétique à compensation de courant selon l'une des revendications précédentes, destiné à former un capteur de l'angle de rotation, **caractérisé en ce que** deux capteurs de champ magnétique à compensation de courant (12, 13) sont agencés perpendiculairement l'un à l'autre et sont exposés à un champ magnétique tournant par rapport aux capteurs de champ magnétique, les signes des courants de compensation dans les deux capteurs de champ magnétique servant à déterminer le quadrant de l'angle de rotation devant être mesuré et le rapport des intensités des courants de compensation servant à la détermination de l'angle à l'intérieur du quadrant.

5. Capteur de champ magnétique à compensation de courant selon la revendication 4, **caractérisé en ce que** la différence des valeurs absolues des tensions des capteurs de champ magnétique dans un quadrant est utilisée pour déterminer si l'angle se trouve dans la première ou la deuxième moitié de ce quadrant, le quotient respectif entre l'intensité réduite et l'intensité accrue des courants de compensation servant de grandeur de mesure pour l'angle.

6. Capteur de champ magnétique à compensation de courant selon la revendication 5, **caractérisé en ce qu'**en vue de la détermination de la relation entre l'angle de rotation et le quotient entre le courant de compensation accru et le courant de compensation réduit, le capteur de l'angle de rotation est compensé par le fait qu'en cas de positions définies de l'angle de rotation à l'intérieur d'un demi-quadrant, la relation est mesurée et enregistrée dans une courbe de référence ou un tableau de référence, un microprocesseur pouvant déterminer, en cas d'une relation définie entre les deux tensions de compensation des capteurs de champ magnétique, l'angle de rotation effectif en vue de l'évaluation des résultats de la relation calculée.

7. Capteur de champ magnétique à compensation de courant selon la revendication 6, **caractérisé en ce que** le tableau de référence est enregistré automatiquement dans une mémoire volatile lors de chaque mise en service.

8. Capteur de champ magnétique à compensation de courant selon la revendication 6, **caractérisé en ce que** le tableau de référence est enregistré une fois pour chaque capteur de l'angle de rotation et mémorisé dans une mémoire non volatile.

9. Capteur de champ magnétique à compensation de courant selon l'une des revendications 6 à 8, **caractérisé en ce que** le champ magnétique est produit pour influencer les capteurs de champ magnétique par des aimants (18, 19) agencés sur un support magnétique (17) relié à l'élément rotatif (16).

10. Capteur de champ magnétique à compensation de courant selon la revendication 8, **caractérisé en ce que** le support magnétique (17) est composé d'un matériau magnétique doux, de sorte à pouvoir servir simultanément de reflux magnétique pour le flux des aimants (18, 19) et de partie du blindage magnétique.

11. Capteur de champ magnétique à compensation de courant selon les revendications 6 à 10, **caractérisé en ce que** les capteurs de champ magnétique (12, 13) sont agencés de manière croisée, de sorte que les noyaux magnétiques des capteurs de champ magnétique se trouvent dans un plan.
